# EUROPEAN PATENT SPECIFICATION

(11) **EP 0 411 818 B1**
(45) Date of publication and mention of the grant of the patent: **14.06.1995**
(21) Application number: 90308152.9
(22) Date of filing: 25.07.1990
(51) Int. Cl.: G11C 11/419, G11C 7/06

(54) **Current sensing amplifier for a memory**
Stromabfühlverstärker für einen Speicher
Amplificateur de détection de courant pour une mémoire

(30) Priority: 04.08.1989 GB 8917835
(43) Date of publication of application: 06.02.1991
(73) Proprietor: SGS-Thomson Microelectronics Limited, Marlow, Buckinghamshire SL7 1YL (GB)
(72) Inventor: Ferris, Andrew Timothy, Fishponds, Bristol BS12 4BS (GB); Work, Gordon Stirling, Great Sankey, Warrington WA5 2SX (GB)
(74) Representative: Driver, Virginia Rozanne

(56) References cited:
- US-A- 4 125 878
- US-A- 4 670 675
- IBM TECHNICAL DISCLOSURE BULLETIN. vol. 26, no. 9, February 1984, NEW YORK USpages 4710 - 4713; D.R.HUFFMAN: 'NOISE-TOLERANT SENSE AMPLIFIER '
- RESEARCH DISCLOSURE. no. 286, February 1988, HAVANT GB page 113; ANONYMOUS:'HIGH SPEED SENSE AMPLIFIER '

## Description

This invention relates to a current sensing amplifier for a memory, and in particular to a dynamic amplifier for use in a low power static random access memory (SRAM).

Semiconductor memories generally include an orthogonal array of memory cells for storing binary data in the form of ones and zeros. In RAMS, usually each memory cell includes two transistors arranged in a cross-coupled flip-flop coupled to a pair of bit lines and a word line. The array typically includes columns of bit lines and rows of word lines. Usually, the bit lines are grouped in pairs. A memory cell is located at each intersection of a bit line pair and a word line. A pair of bit lines can be selectively coupled to data lines under the control of one of a number of column select lines which originate from a column address decoder. Each of the word lines which originate from a row address decoder can selectively couple the memory cells in that row to their corresponding bit lines by turning on access transistors in the memory cell. Input addresses are decoded by the column address decoders and row address decoders to couple a particular memory cell, i.e., the memory cell located at the intersection of the selected bit lines and word lines, to the data lines. In this manner binary data stored in the memory cells may be transferred to the bit lines and then to the data lines for eventual transfer to a memory output device. Data is written into the memory cells in the same general manner.

Between the data lines and the memory output device there is required sensing circuitry, or so-called sense amplifiers. Conventional sense amplifiers for SRAMs have sensed a voltage differential between the bit lines. The voltage difference typically developed between bit lines is of the order of 5% to 10% of the device supply voltage. Thus for a 5 volt supply, the bit line voltage differential is in the 0.25 to 0.5 volt range.

Existing static voltage sensing amplifiers continuously sense the bit line voltage differential and produce as an output an amplified version of this differential. The gain of the amplifier needs to be high and to this end the amplifier comprises several conventional differential amplification stages the output of one supplying the input of the next to achieve a sufficiently high gain to drive the memory output device. This type of sensing circuitry suffers from several disadvantages. The requirement for several amplification stages means that the circuitry occupies a large amount of chip area and also has a high power requirement. In addition, accurate voltage references must be provided for each amplification stage.

There also exist dynamic voltage sensing amplifiers which operate by taking a "snap shot" of the voltage differential at a particular instant. This instant is determined by a sense clock φ at a time when sufficient voltage differential to be sensed reliably has developed across the data lines. Such amplifiers are smaller and consume less power than static sensing amplifiers, but are still reliant for their operation on sensing the voltage differential.

One problem with sensing the voltage differential between the bit lines is that the bit lines and data lines are capacitively loaded. Accordingly, the generation of the required voltage differential involves a time delay. The time delay caused by the capacitance necessarily increases the time required to read data from a memory cell.

Further disadvantages of using sensing techniques which depend on the voltage differential between the bit lines are the difficulty in obtaining optimal signal gain from the sense amplifiers and in shifting the common mode voltage level on the bit lines before the differential signal can be used as a memory output signal. Both of these problems are caused by the fact that the bit lines must be maintained above a voltage equal to about 80% of the device supply voltage to preserve memory cell stability.

There has been an attempt to solve the problem of measuring bit line voltage differentials in RAMs. In this regard reference is made to US Patent No. 4 766 333 which describes a static sensing amplifier which, instead of sensing voltage differentials on the bit lines, senses the difference between respective currents supplied along the bit lines. Two current sources are connected respectively to the bit lines and supply respective currents Icm. When accessed, a cell takes a drive current of Icell, the direction of which depends on the data held in the cell. Hence a current differential appears across the data lines.

This amplifier does possess the advantage of not needing to wait for bit line voltage differentials to be developed. It is therefore faster than the above-mentioned voltage static sensing amplifier. However it shares the other disadvantages of a voltage static sensing amplifier, namely it is large and consumptive of power.

It is an object of the invention to provide a sensing amplifier for a RAM which obviates or at least mitigates the disadvantages of the prior art expressed above.

According to the present invention there is provided a dynamic sensing amplifier for connection across data lines of a memory to sense the difference in current signals carried respectively by said data lines which amplifier comprises first and second input elements each input element having a control node and first and second connection nodes between which is a controllable path, the input elements being cross-coupled by connecting the control node of one to receive a signal on the controllable path of the other and vice-versa, the first connection node of each input element being connected to receive a respective one of said data line currents, first and second loads connected respectively to the second connection nodes of the first and second input elements and across which respective output voltages are developed, and a switch element between the control nodes of the input elements and operable in a first state thereof to hold the amplifier in a state of equilibrium in which the output voltages are substantially the same and in a second state thereof to enable the input elements to drive the output voltages so as to latch the amplifier into one of two logic states depending on the sense of the difference in the data line currents.

Preferably the input elements are field effect transistors (FETs) in which case the gate of the transistor is the control node and the drain/source channel is the controllable path.

Preferably the loads are respective FETs with their drain/source channels connected in the drain/source channels of the first and second input elements. The loads can be cross-coupled by connecting their gates to the gates of the first and second input FETs.

Preferably the switch element has a control node arranged to receive a switching signal and a controllable path connected between the control nodes of the input elements. In the preferred embodiment the switch element is an FET transistor whose gate is the control node and the drain/source channel of which is the controllable path.

Preferably the switching signal is a clock pulse.

For a better understanding of the invention and to show how the same may be carried into effect, reference will now be made by way of example to the accompanying drawings, in which:-
Figure 1 is a diagram of a basic memory layout;
Figure 2 shows part of a memory array;
Figure 3 shows one cell of a memory array;
Figure 4 is a block diagram of a basic current sensing system;
Figure 5 is a circuit diagram of a "dynamic" current sensing amplifier illustrating the principle of the invention;
Figure 6 is a circuit diagram of a "dynamic" current sensing amplifier in accordance with one embodiment of the present invention; and
Figure 7 is a graph of drain/source current vs drain/source voltage for the input transistors of the amplifier.

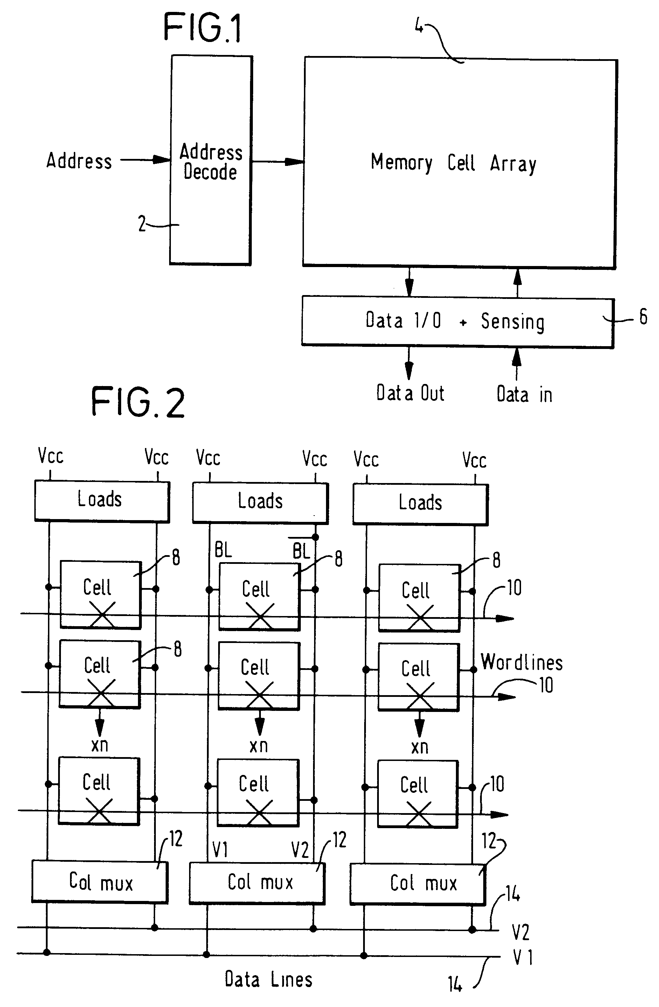

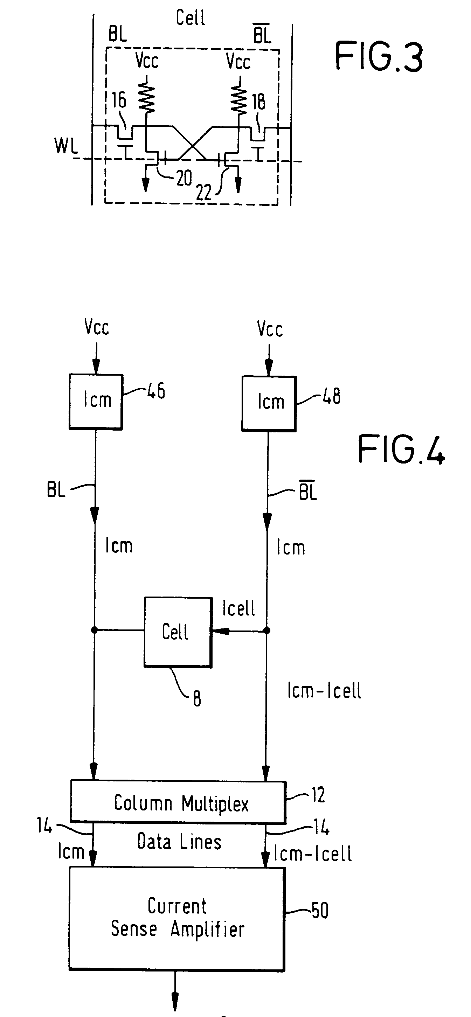

By way of background, reference is made to Figures 1 to 3 of the present application. Figure 1 shows a typical memory device for use with a voltage sensing amplifier and which comprises three main components: address decoding circuitry 2, memory cell array 4 and data sensing circuitry 6. A segment of a memory cell array is shown in Figure 2. A plurality of memory cells 8 are arranged in rows and columns, all the cells in a single column sharing a pair of bit lines BL, B̅L̅. Each pair of bit lines is connected to a respective column multiplexer 12 which in turn is connected to output data lines 14. All the cells in a row are connected to a common wordline 10. The internal structure of a cell is shown in Figure 3. The cell to be accessed is determined by the wordline signals and by the column multiplexer. When the potential of a wordline 10 is raised, access transistors 16, 18 of the cell turn on and create a discharge path from one of the bit lines BL or B̅L̅ depending on the state of the cell. This gives rise to a potential difference ΔV between the bit lines BL, B̅L̅ where ΔV=V₁ - V₂, and, via the column multiplexer, on the data lines.

The function of the data sensing circuitry 6 is to sense the potential difference ΔV, in particular whether it is positive or negative, thereby to determine the binary state of the accessed cell. The present invention achieves this based on the principle of current (rather than voltage) sensing.

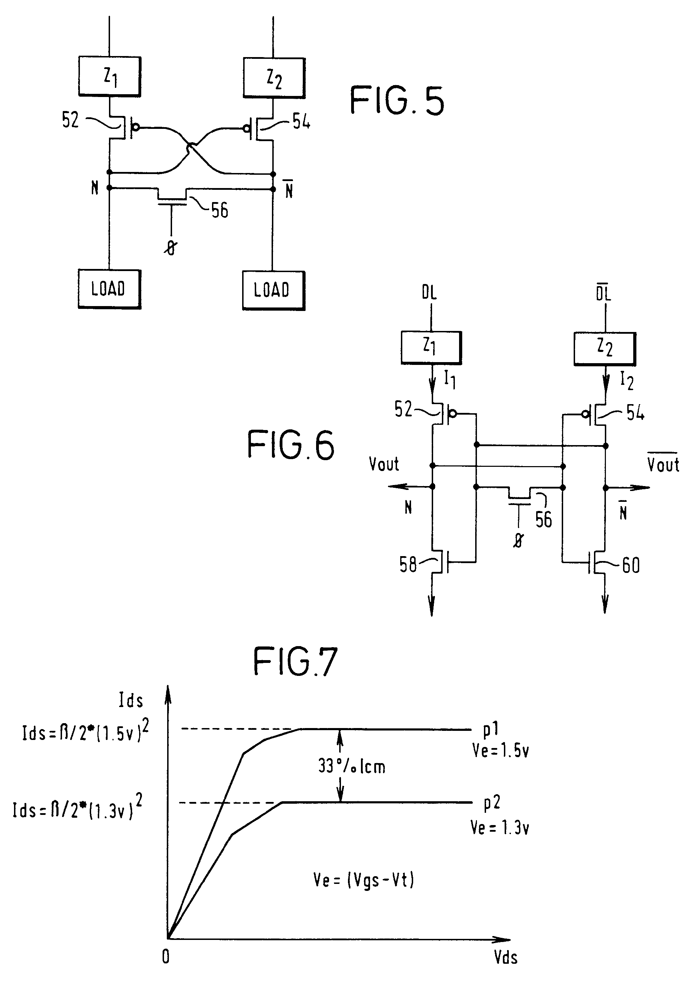

Figure 4 illustrates the idealised principle of current sensing. Two current sources 46, 48 are connected respectively to supply currents Icm through the bit lines BL, B̅L̅. When the cell 8 is accessed, it takes a current Icell so that the currents appearing on the data lines 14 (Icm, Icm-Icell) are different by a value Icell and in a sense which depends on the data stored in the cell. Reference numeral 50 designates a current sensing amplifier. The difference in data line currents manifests itself to the current sensing amplifier 50 as a mismatch in impedances on the bit lines. An amplifier using this principle which operates as a static sensing amplifier has been described in the above referenced US Patent No. 4 766 333. The present invention applies the current sensing principle to dynamic sensing as discussed below with reference to Figure 5.

As described above, an accessed memory cell manifests itself to the current sensing amplifier 50 as a mismatch in impedences on the data lines, these impedances being represented by Z₁, Z₂ in Figure 5.

The sensing amplifier comprises two input p-channel transistors 52, 54, the gate of one being connected to the drain of the other so that they are cross-coupled. The sources of the transistors 52,54 are connected to receive current flowing along the data lines 14, DL, D̅L̅ respectively. A switch element in the form of a third, n-channel transistor 56 is connected with its drain/source channel between the gates of the transistors 52, 54 and with its own gate connected to receive a clock signal φ. Loads are connected respectively in the drains of the transistors 52, 54, output voltages Vo, V̅o̅ of the amplifier being developed across these loads at output nodes N, N̅. In the preferred embodiment shown in Figure 6, the loads are n-channel transistors 58, 60 the gates of which are connected to the gates of the input transistors 52, 54 respectively.

When the clock signal φ is high the gate voltages of the two p-channel transistors 52, 54, and of the load transistors 58, 60, are such that these transistors are biased in saturation and the output voltages Vo, V̅o̅ are held equal (or nearly equal) despite the difference in currents on the data lines DL, D̅L̅. Consider currents I₁, I₂ on the data lines DL, D̅L̅ respectively where I₂ > I₁. That is I₂ represents Icm and I₁ represents Icm-Icell. The load transistors are each biased to pass a drain current I₃, where I₂ > I₃ > I₁. With the transistor 56 turned ON, the differential current I₂-I₃ can flow from the drain of transistor 54, via the transistor 56 and to the drain of transistor 58 to supplement the current I₁ from the transistor 52. The output voltages Vo, V̅o̅ are hence determined by the Vds/Vg characteristic for the load transistors. When the clock signal goes low, and the transistor 56 is turned OFF the difference in currents drives the output voltages Vo, V̅o̅ in opposite directions to develop an output voltage differential. That is, there is no longer an equalising current path so the current differential I₂-I₃ at the output node N̅ causes that node to be charged up (due to the effect of parasitic capacitance at that node N̅) and hence V̅o̅ increases. Concurrently, the output node N̅ is depleted by the current differential I₃-I₁ causing Vo to reduce. As more voltage at node N develops across the load 60, the gate-source voltage of the transistor 52 is reduced, hence reducing the current passed by that transistor 52 and depleting node N still further. Conversely depletion of the node N results in a larger gate-source voltage for the transistor 54 and hence a larger drain current. The speed at which the output voltages are driven in opposite directions is hence increased by feedback between the two transistors 52, 54 arising from their cross-coupling and also by the cross-coupling of the load transistors 58, 60. The output voltages quickly reach a level close to normal CMOS logic levels of 5V and OV respectively so that no further latching or amplification circuitry is required. The data is hence in a form suitable for use by the appropriate "back end" circuitry.

The circuit of Figure 5 has the advantage over voltage sensing circuitry in that it is quicker in its operation because it does not rely on the development of a voltage differential between the bit lines BL, B̅L̅ which is sufficiently high for sensing, for example a minimum of 300mV.

Another advantage of the above described sense amplifier over conventional designs is that the circuit is 'self biasing', i.e. no voltage reference levels are needed to obtain optimum performance from the amplifier, and also the design can tolerate large variations in common mode input levels. This latter tolerance is important in ensuring optimum performance after memory WRITE cycles, aborted READ cycles or during power rail disturbances, where precise common mode voltage levels are not always guaranteed. The circuit will easily tolerate common mode voltage variations in the 3V to 5V range (assuming transistor threshold voltages Vtn, Vtp of approximately 0.7V, -0.7V.).

In memories where reference voltages must be generated to bias the sense amplifier into its most sensitive region, power supply noise and degraded bitline levels may adversely effect the sense margin.

The sensing amplifier is made using matched transistors for the input transistors and load transistors respectively. Matched transistors are those which under the same conditions of gate source voltage (Vgs), drain source voltage (Vds) and substrate voltage (Vsubstrate) have identical drain/source currents. Production techniques may lead to differences of up to 10% in drain currents of two nominally matched transistors, but these remain for many applications acceptable as matched transistors.

However, production techniques do not always result in perfectly matched transistors, or even transistors matched to within 10%. It is an important advantage of the present circuit that it is insensitive to a high degree of mismatch in its respective input transistors and load transistors. Figure 7 shows the characteristics of the two input transistors 52, 54, with the sense amplifier in equilibrium during a typical access. Both transistors are in saturation and in this state the relationship between Ids and Vgs is determined by Ids = β/₂ (Vgs-Vt)², where β is the transconductance factor. From the graph it can be seen that a difference Idiff of 33% in the current Icm is obtained. Before unreliable sensing will occur, a device offset of approximately 30% in the drain source current Ids would be needed.

An offset of 30% would also be required in the load transistor with these transistors also matched and biased in saturation.

It is clear that this sense amplifier with matched transistors easily satisfies the criteria for reliable sensing.

Note that this reliable sensing can be achieved with a very low voltage differential on the bit lines, for example in the example discussed with reference to Figure 6, this would be 200mV. Where the transistors are more closely matched, even lower voltage differentials can be sensed.

To achieve optimum performance with this sense amplifier it is desirable for the p devices to be large relative to the n devices, i.e. in equilibrium the p devices have a small absolute Ve (Vgs-Vt), and therefore have a high differential current gain for small changes in Vgs. Increasing the p device transistor sizes reduces the bitline voltage differential but increases the sensed current differential.

Advantages over the static current sensing arrangement of US 4 766 333 include the fact that the present circuit occupies less space on chip, uses less components and is less consumptive of power. Further, near CMOS logic levels are provided as a direct output: there is no need for conversion of an analogue level to a digital level as required in US 4 766 333 to drive subsequently connected logic circuitry.

## Claims

1. A dynamic sensing amplifier for connection across data lines of a memory to sense the difference in current signals carried respectively by said data lines which amplifier comprises first and second input elements (52, 54) each input element having a control node and first and second connection nodes between which is a controllable path, the input elements being cross-coupled by connecting the control node of one to receive a signal on the controllable path of the other and vice-versa, the first connection node of each input element being connected to receive a respective one of said data line currents, first and second loads (58, 60) connected respectively to the second connection nodes of the first and second input elements (52, 54) and across which respective output voltages are developed, and a switch element (56) between the control nodes of the input elements and operable in a first state thereof to hold the amplifier in a state of equilibrium in which the output voltages are substantially the same and in a second state thereof to enable the input elements to drive the output voltages so as to latch the amplifier into one of two logic states depending on the sense of the difference in the data line currents.

2. An amplifier as claimed in claim 1, wherein the input elements are FET transistors, having a gate constituting said control node and a drain/source channel constituting said controllable path.

3. An amplifier as claimed in claim 1 or 2, wherein the switch element has a control node arranged to receive a switching signal and a controllable path connected between the control nodes of the input elements.

4. An amplifier as claimed in claim 3, wherein the switch element is an FET transistor having a gate constituting said control node and a drain/source channel constituting said controllable path.

5. An amplifier as claimed in any preceding claim, in combination with a clock pulse generator, the switching signal being a clock pulse generated by said generator.

## Patentansprüche

1. Ein dynamischer Abtastverstärker zum Parallelschalten von Datenleitungen eines Speichers, um die Unterschiede der Stromsignale, die jeweils von den Datenleitungen geführt werden, abzutasten, wobei der Verstärker erste und zweite Eingangselemente (52, 54), wobei jedes Eingangselement einen Steuerknoten und erste und zweite Verbindungsknoten hat, zwischen denen ein steuerbarer Pfad liegt, wobei die Eingangselemente mittels Verbindung der Steuerknoten der einen, um ein Signal auf dem steuerbaren Pfad der anderen zu erhalten, und umgekehrt kreuzgekoppelt sind, wobei der erste Verbindungsknoten eines jeden Eingangselements so verbunden ist, daß er einen jeweiligen der Datenleitungsströme empfängt, erste und zweite Lasten (58, 60), die jeweilig mit den zweiten Verbindungsknoten der ersten und zweiten Eingangselemente (52, 54) verbunden sind und über denen sich jeweilige Ausgangspannungen entwickeln, und ein Schaltelement (56) aufweist, welches zwischen den Steuerknoten der Eingangselemente liegt und welches in einem ersten Zustand, um den Verstärker in einem Gleichgewichtszustand zu halten, in welchem die Ausgangspannungen im wesentlichen gleich sind, und in einem zweiten Zustand betreibbar ist, um die Eingangselemente zur Ansteuerung der Ausgangspannungen freizugeben, so daß der Verstärker in einen von zwei logischen Zuständen abhängig von den Datenleitungströmen einrastet.

2. Ein Verstärker gemäß Anspruch 1, bei dem die Eingangselemente FET-Transistoren mit einem Gate, welches den Steuerknoten bildet, und einem Drain/Source-Kanal, der den steuerbaren Pfad bildet, sind.

3. Ein Verstärker gemäß Anspruch 2 oder 3, bei dem das Schaltelement einen Steuerknoten, der so angeordnet ist, daß er ein Schaltsignal empfängt, und einen steuerbaren Pfad aufweist, der zwischen die Steuerknoten der Eingangselemente geschaltet ist.

4. Ein Verstärker gemäß Anspruch 3, bei dem das Schaltelement ein FET-Transistor mit einem Gate, das den Steuerknoten bildet, und einem Drain/Source-Kanal, das den steuerbaren Pfad bildet, ist.

5. Ein Verstärker gemäß einem der vorhergehenden Ansprüche in Verbindung mit einem Taktimpulsgenerator, wobei das Schaltsignal ein durch den Generator erzeugter Taktimpuls ist.

## Revendications

1. Un amplificateur de lecture dynamique destiné à être connecté entre des conducteurs de données d'une mémoire, pour détecter la différence entre des signaux de courant qui sont respectivement acheminés par ces conducteurs de données, cet amplificateur comprenant des premier et second éléments d'entrée (52, 54), chaque élément d'entrée ayant un noeud de commande et des premier et second noeuds de connexion entre lesquels se trouve un chemin commandé, les éléments d'entrée étant connectés en couplage croisé par la connexion du noeud de commande de l'un de manière à recevoir un signal sur le chemin commandé de l'autre, et réciproquement, le premier noeud de connexion de chaque élément d'entrée étant connecté de façon à recevoir l'un respectif des courants de conducteurs de données, des première et seconde charges (58, 60) respectivement connectées aux seconds noeuds de connexion des premier et second éléments d'entrée (52, 54), et aux bornes desquelles apparaissent des tensions de sortie respectives, et un élément de commutation (56) qui est connecté entre les noeuds de commande des éléments d'entrée et qui, dans un premier état, maintient l'amplificateur dans un état d'équilibre dans lequel les tensions de sortie sont pratiquement les mêmes, et dans un second état, permet aux éléments d'entrée de faire varier les tensions de sortie de façon à verrouiller l'amplificateur dans l'un de deux états logiques, en fonction du sens de la différence entre les courants des conducteurs de données.

2. Un amplificateur selon la revendication 1, dans lequel les éléments d'entrée sont des transistors à effet de champ, ayant une grille qui constitue le noeud de commande, et un canal drain/source qui constitue le chemin commandé.

3. Un amplificateur selon la revendication 1 ou 2, dans lequel l'élément de commutation comporte un noeud de commande destiné à recevoir un signal de commutation, et un chemin commandé qui est connecté entre les noeuds de commande des éléments d'entrée.

4. Un amplificateur selon la revendication 3, dans lequel l'élément de comutation est un transistor à effet de champ ayant une grille qui constitue le noeud de commande, et un canal drain/source qui constitue le chemin commandé.

5. Un amplificateur selon l'une quelconque des revendications précédentes, en combinaison avec un générateur d'impulsions d'horloge, le signal de commutation étant une impulsion d'horloge qui est produite par ce générateur.
